# EUROPEAN PATENT APPLICATION

(11) **EP 1 862 562 A1**
(43) Date of publication of application: **05.12.2007**
(21) Application number: 07009640.9
(22) Date of filing: 14.05.2007
(51) Int. Cl.: C23C 14/14, C23C 14/24, C23C 14/34, C23C 14/50, C23C 14/58

(54) **Method for manufacturing substrate, and vapor deposition apparatus used for the same**

(30) Priority: 31.05.2006 JP 2006151852
(71) Applicant: MEC COMPANY LTD., Amagasaki-shi, Hyogo 660-0832 (JP)
(72) Inventor: Otani, Minoru, Amagasaki-shi Hyogo 660-0832 (JP); Morinaga, Yukari, Amagasaki-shi Hyogo 660-0832 (JP)
(74) Representative: Schwarzensteiner, Marie-Luise

(57) **Abstract**

A method for manufacturing a substrate according to the present invention includes the steps of: positioning a copper layer forming material (20) including a constituent material of a copper layer and a base (21) such that the base (21) faces the copper layer forming material (20) in a position vertically above the copper layer forming material (20); and vapor-depositing copper on the base by heating the copper layer forming material (20) to a temperature range of 90 to 200°C and heating the base (21) to a temperature range of 120 to 450°C, thereby forming the copper layer. Thus, a method for manufacturing a substrate that includes a fine copper layer having a high copper purity with safety at low cost, which is suitable for manufacturing a semiconductor substrate, an electronic substrate, etc. is provided, and a vapor deposition apparatus used for the method is provided.

## Description

The present invention relates to a method for manufacturing substrates such as a semiconductor substrate and an electronic substrate, and a vapor deposition apparatus used for the method.

Conventionally, a semiconductor substrate on which a wiring layer made of an aluminum alloy is formed on a semiconductor base has been used (see e.g., JP 2005-340640A). However, with the recent development of highly integrated semiconductor circuits, the signal delay caused by conventional aluminum-based metal wires has become greater, for example, due to the increased wiring resistance resulting from an increase in the wire length, and this is a hindrance to improvement of the operating speed. Therefore, a semiconductor substrate using copper, which has a lower resistivity than that of an aluminum alloy, has been suggested as a wiring material (see e.g., JP 7-283219A and JP 2001-23932A). In the case of the semiconductor substrate using copper as the wiring material, a copper layer (copper wiring layer) usually is formed on a semiconductor base by electroplating, metallorganic chemical vapor deposition (MOCVD) or the like.

However, in the case of forming the copper layer by electroplating, it is necessary to form a seed layer, and there is a problem in that the seed layer cannot be formed completely to the bottom of a fine contact when forming the fine contact, resulting in incomplete embedding of copper. In the case of forming the copper layer by MOCVD, it is necessary to use an expensive organometallic compound, and to process a harmful exhaust gas. Moreover, a copper layer formed by MOCVD tends to have a low copper purity.

On the other hand, in the case of an electronic substrate, such as a printed circuit substrate or a semiconductor package substrate, other than a semiconductor substrate, the copper layer conventionally has been formed by electroless plating. However, forming the copper layer by electroless plating leads to the generation of liquid wastes, thus placing a great burden on the environment. Recently, this has caused the problem of high costs for processing the liquid wastes.

The present invention was made in view of the foregoing circumstances, and provides a method for manufacturing a substrate that includes a fine copper layer having a high copper purity with safety and at low cost, which is suitable for manufacturing a semiconductor substrate, an electronic substrate, etc., and provides a vapor deposition apparatus used for the method.

A method for manufacturing a substrate according to the present invention is a method for manufacturing a substrate including a base, and a copper layer formed on the base. The method includes the steps of
positioning a copper layer forming material includes a constituent material of the copper layer and the base such that the base faces the copper layer forming material in a position vertically above the copper layer forming material; and
vapor-depositing copper on the base by heating the copper layer forming material to a temperature range of 90 to 200°C and heating the base to a temperature range of 120 to 450°C, thereby forming the copper layer.

A vapor deposition apparatus according to the present invention is a vapor deposition apparatus for manufacturing a substrate including a base, and a copper layer formed on the base, the apparatus including:
a material placement portion for positioning a copper layer forming material including a constituent material of the copper layer;
a base placement portion for positioning the base, the base placement portion being provided facing the material placement portion in a position vertically above the material placement portion;
a material heating portion for heating the copper layer forming material to a temperature range of 90 to 200°C; and
a base heating portion for heating the base to a temperature range of 120 to 450°C.

FIG. 1 is a flowchart illustrating a method for manufacturing semiconductor substrate according to one embodiment of the present invention.
FIG. 2 is a diagram schematically showing an example of the apparatus used for the method for manufacturing a semiconductor substrate shown in FIG. 1.
FIG. 3 is a diagram schematically showing an example of the apparatus used for the method for manufacturing a semiconductor substrate shown in FIG. 1.
FIG. 4 shows a spectrum illustrating the results of analyzing an example of the present invention by ESCA.
FIG. 5 shows a spectrum illustrating the results of analyzing an example of the present invention by ESCA.
FIG. 6 shows a spectrum illustrating the results of analyzing an example of the present invention by ESCA.

The method for manufacturing a substrate according to the present invention can be used as a method for manufacturing a substrate including a base, and a copper layer formed on this base. Examples of the substrates manufactured according to the present invention include a semiconductor substrate, and an electronic substrate such as a printed circuit substrate or a semiconductor package substrate, and the method for manufacturing a substrate of the present invention is particularly suitable as a method for manufacturing a semiconductor substrate.

Although there is no particular limitation with respect to the constituent material of the base, a base made of silicon, sapphire, GaAs (gallium arsenide) or the like can be used as the base for a semiconductor substrate. For example, it is preferable to use a silicon wafer of 40 to 300 mmφ.

An electrically insulating base can be used as the base for an electronic substrate, and examples thereof include bases made of thermoplastic resins such as an acrylonitrile-styrene copolymer (AS) resin, an acrylonitrile-butadiene-styrene copolymer (ABS) resin, a fluorocarbon resin, polyamide, polyethylene, polyethylene terephthalate, polyvinylidene chloride, polyvinyl chloride, polycarbonate, polystyrene, polysulfone, polypropylene, and a liquid crystal polymer, bases made of thermosetting resins such as an epoxy resin, a phenol resin, polyimide, polyurethane, a bismaleimide triazine resin and a modified polyphenylene ether, and bases obtained by reinforcing the resins listed above with glass fiber, aramid fiber or the like. It is also possible to use bases made of ceramics, glass and the like.

In the method for manufacturing a substrate according to the present invention, a copper layer forming material including a constituent material of the copper layer and the base are disposed such that base faces the copper layer forming material in a position vertically above the copper layer forming material. More specifically, the copper layer forming material is decomposed, whereby a metal precursor is generated and vaporized. The vaporized gas is impinged onto the base, whereby the metal can be vapor-deposited. In the above-description, the phrase of "the base faces the copper layer forming material in a position vertically above the copper layer forming material" means that a surface of the base on which a metal is to be vapor-deposited is oriented in a direction such that the gas vaporized from the copper layer forming material is impinged onto the foregoing surface. It should be noted that, to vapor-deposit the metal uniformly, it is preferable that the surface of the base and the copper layer forming material are disposed at uniform distances at any positions, i.e. disposed in parallel with each other.

Then, copper is vapor-deposited on the base by heating the copper layer forming material to a temperature range of 90 to 200°C (preferably 120 to 180°C) and heating the base to a temperature range of 120 to 450°C (preferably 150 to 300°C), thereby forming the copper layer. When a temperature of the copper layer forming material is lower than the above-described temperature range, it may be difficult to vapor-deposit copper because the decomposition reaction of the copper layer forming material does not occur at such a low temperature and hence the vaporization of the metal precursor does not occur. On the other hand, when the temperature of the base is higher than the above-described temperature range, high energy is required, which may lead to a waste of cost and time. When the temperature of the copper layer forming material is higher than the above-described temperature range, the metallization reaction may proceed before vaporization, so that copper may not be vapor-deposited on the base. It should be noted that the heating temperatures for the base and the copper layer forming material preferably are set within the above-described ranges such that the temperature of the base is higher than that of the copper layer forming material. Regarding the heating of the copper layer forming material, it is preferable that after the copper layer forming material is heated to a temperature (90 to 130°C) at which the decomposition reaction starts, the temperature is gradually raised to the intended level, because the precursor of metallic copper is vaporized easily. The foregoing expression "gradually" means a low temperature increasing rate of, preferably, not more than about 10°C/min, and more preferably not more than about 5°C/min.

It should be noted that preferably the temperature of the base is increased to 120°C to 450°C by the time when the temperature of the copper layer forming material reaches 90°C to 130°C.

By vapor-depositing copper under the above-described conditions, it is possible to manufacture a substrate including a copper layer having a high copper purity with safety and at low cost. Furthermore, since it is not necessary to use a seed layer as used for electroplating, it is possible to manufacture a substrate including a fine copper layer. Preferred examples of the copper layer forming material will be described later, though it may be anything as long as it can be decomposed at a specific temperature so that a precursor of the metallic copper can be vaporized.

The copper layer forming material and the base are disposed such that the space between the copper layer forming material and the base is preferably 5 to 100 mm, and more preferably 10 to 50 mm. When the space is shorter than the above-described range, a residue of the copper layer forming material may attach to the base. When the space is longer than the above-described range, on the other hand, it may be difficult to deposit copper on the base in a predetermined thickness.

The copper layer forming material may be a material including a copper compound including one unit represented by Formula (1) below or a plurality of the units that are coupled together:

Formula (1) [RCOO]₂[NH₃]₂CuXₚ

wherein two Rs each represent one selected from H, NH₂, CH₂Y, CH₂Y (CHZ) and CH₂Y (CHZ)₄, and may be either the same or different,
X represents H₂O or a solvent molecule,
p is 0 or 1,
Y represents one selected from H, OH and NH₂, and
Z represents one selected from H and OH.

Although there is no particular limitation with respect to the method for manufacturing the copper compound, the copper compound may be manufactured, for example, by reacting a compound formed by a carboxylic acid and copper, such as copper formate, with ammonia water. It also may be manufactured by reacting copper oxide with a carboxylic acid such as formic acid, followed by reaction with ammonia water.

When producing the copper layer forming material, a precursor material for producing the copper layer forming material may be prepared, for example, by dissolving the copper compound in a low boiling point solvent. The copper layer forming material also may be produced, for example, by uniformly applying this precursor material onto a dish-shaped jig, and then distilling away the low boiling point solvent.

As the low boiling point solvent in which the copper compound is dissolved, it is preferable to use a solvent having a boiling point of 120°C or lower under normal pressure. Examples thereof include water, methanol, ethanol, isopropyl alcohol (IPA), n-propyl alcohol, isobutanol and n-butanol.

The concentration of the copper compound in the precursor material preferably is 10 to 300 g/L, more preferably 40 to 100 g/L. When the concentration is higher than the above-described range, the copper compound may be precipitated. When the concentration is lower than the above-described range, on the other hand, it may be necessary to distill away a large amount of the low boiling point solvent, leading to a waste of time and cost. The thickness of the copper layer can be adjusted freely by increasing the above-described concentration in order to increase the thickness of the resulting copper layer, and decreasing the above-described concentration in order to reduce the thickness.

In the case of preparing the precursor material by dissolving the copper compound in a low boiling point solvent, ammonia further may be added in order to improve the solubility of the copper compound. In this case, the amount of ammonia added is about 0.2 to 5 wt%. When the amount of ammonia added is less than the above-described range, the copper compound may be difficult to dissolve. When the amount is greater than the above-described range, a further effect may not be obtained, leading to a waste of time and cost. A high boiling point solvent further may be added as a heating medium. As the high boiling point solvent, it is possible to use, for example, a solvent that has a boiling point of 140°C or higher under normal pressure, and evaporates at a temperature of 120°C or lower at a pressure of 1 Pa. More specifically, it is possible to use propylene glycol, benzyl alcohol, butylene glycol, a phthalic acid ester, linalool and cyclohexanol. In this case, the amount of the high boiling point solvent added may be 15 wt% or lower, for example. When the amount exceeds 15 wt%, the vapor deposition of copper may be hindered. A stabilizer further may be added. As the stabilizer, it is possible to use, for example, ammonium formate. By adding the stabilizer, it is possible to suppress the formation of a by-product during the distillation, and also to aid in vapor-depositing only metallic copper from the copper compound on the base during vapor deposition. In this case, the amount of the stabilizer added may be 0.1 to 20 wt%, for example, and preferably 1 to 10 wt%. When the amount of the stabilizer added is less than 0.1 wt%, it may not be possible to achieve the effect of the stabilizer. When the amount exceeds 20 wt%, it may not be possible to achieve a further effect, leading to a waste of time and cost.

When producing the copper layer forming material, it is not always necessary to use a solvent. The copper layer forming material may be produced, for example, by attaching the copper compound onto a source material placement base (a base for disposing a source material) by means of an adhesive. As the source material placement base, it is possible to use, for example, a polyimide film and a stainless steel plate. As the adhesive, it is possible to use, for example, a silicone-based adhesive. When attaching the copper compound onto the source material placement base, the copper compound may be sprinkled onto the source material placement base with sprinkling means such as a commonly used powder-sprinkling apparatus. Further, the copper compound uniformly can be attached onto the source material placement base by sprinkling an excessive amount of the copper compound onto the source material placement base, and thereafter removing any excess portion from the source material placement base. Additionally, forming irregularities on the bonding surface of the source material placement base can increase the amount of the copper compound attached, thus facilitating the adjustment of the thickness of the resulting copper layer. To form irregularities on the bonding surface, an embossing roll or the like may be pressed onto the surface of the source material placement base when manufacturing the source material placement base.

The copper layer forming material need not necessarily contain the copper compound. For example, the copper layer forming material may be a material containing a formate ion, a copper ion and an ammonium ion. The precursor material may be prepared, for example, by dissolving the above-described ions in a low boiling point solvent. In this case, by adjusting the amount of the formate ion and the ammonium ion added, it is possible to achieve an effect similar to that obtained by adding ammonium formate, which serves as a stabilizer. As the low boiling point solvent, it is possible to use the same solvent as that used for the copper compound.

In the case of preparing the precursor material by dissolving the above-described ions in a low boiling point solvent, the concentrations of the ions may be, for example, as follows: 5 to 220 g/L (preferably 20 to 60 g/L) formate ion, 1 to 120 g/L (preferably 10 to 35 g/L) copper ion, and 4 to 350 g/L (preferably 5 to 50 g/L) ammonium ion. When the concentrations of the ions are higher than the above-described ranges, a precipitate may be produced. When the concentrations are lower than the above-described ranges, on the other hand, it may be necessary to distill away a large amount of the low boiling point solvent, leading to a waste of time and cost. The thickness of the copper layer can be adjusted freely by increasing the above-described concentrations in order to increase the thickness of the resulting copper layer, and decreasing the above-described concentrations in order to reduce the thickness.

In the manufacturing method of the present invention, it is preferable that the copper layer forming material and the base are heated with the pressure around the copper layer forming material and the base maintained at 1000 Pa or lower. When the pressure exceeds 1000 Pa, it may be difficult to vapor-deposit copper, because a precursor of metallic copper may be difficult to vaporize from the copper layer forming material. In order to reduce the manufacturing cost, it is preferable to carry out the heating, with the pressure maintained in the range of 1 to 1000 Pa.

According to the present invention, it is preferable that, after forming the copper layer, the base is cooled under an inert atmosphere. When the copper layer is exposed in the air immediately after vapor deposition, the surface of the copper layer may be oxidized, thus increasing the resistance value. However, when the copper layer is exposed in the air after the cooling under an inert atmosphere, it is possible to prevent oxidation of the surface of the copper layer. "Under an inert atmosphere" as mentioned herein refers to a state in which oxidation of copper will not occur. Examples of the method for providing an inert atmosphere include a method that provides a vacuum state at 100 Pa or lower, a method that provides a vacuum state at 1000 Pa or lower, with oxygen being substituted with an inert gas such as nitrogen gas or argon gas, and a method that provides a state in which a large amount of an inert gas is introduced at normal pressure. Furthermore, in order reliably to prevent the oxidation of the surface of the copper layer, the base is cooled until the temperature of the base reaches preferably 100°C or lower, and more preferably 60°C or lower. Examples of the cooling method used in this case include discharging an inert gas such as nitrogen or argon into a treatment chamber as a cooling gas, or moving the obtained substrate onto a cooling jig made of metal or the like, followed by cooling.

Next, the vapor deposition apparatus of the present invention will be described. It should be noted that the vapor deposition apparatus of the present invention is a vapor deposition apparatus that is suitably used for the above-described method for manufacturing a substrate according to the present invention. Therefore, the content overlapping with the above description has been omitted.

A vapor deposition apparatus according to the present invention includes a material placement portion for positioning a copper layer forming material including a constituent material of the copper layer; a base placement portion for positioning the base, the base placement portion being provided facing the material placement portion in a position vertically above the material placement portion; a material heating portion for heating the copper layer forming material to a temperature range of 90 to 200°C; and a base heating portion for heating the base to a temperature range of 120 to 450°C. With this apparatus, it is possible to manufacture a substrate including a fine copper layer having a high copper purity with safety and at low cost.

The vapor deposition apparatus of the present invention further may include a cooler for cooling the base. The reason is that this makes it possible to prevent oxidation of the surface of the obtained copper layer. Examples of the cooler include a gas discharger for discharging a cooling gas (e.g., an inert gas such as nitrogen or argon) into a chamber.

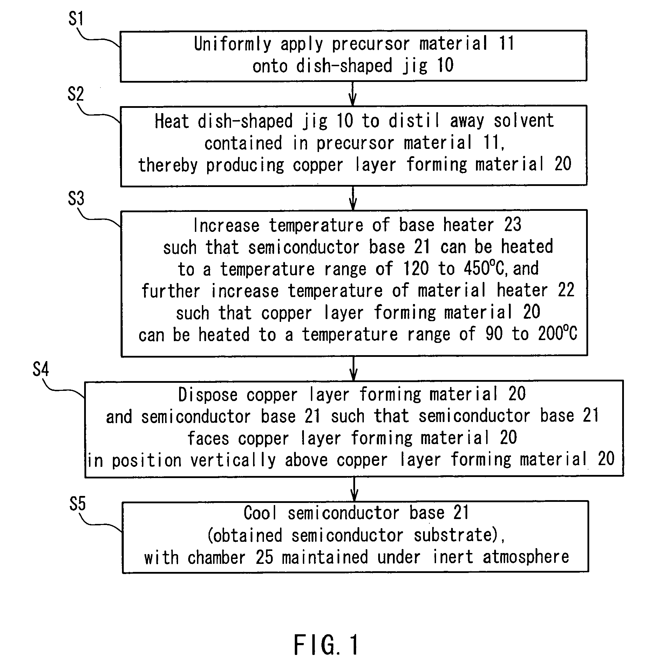

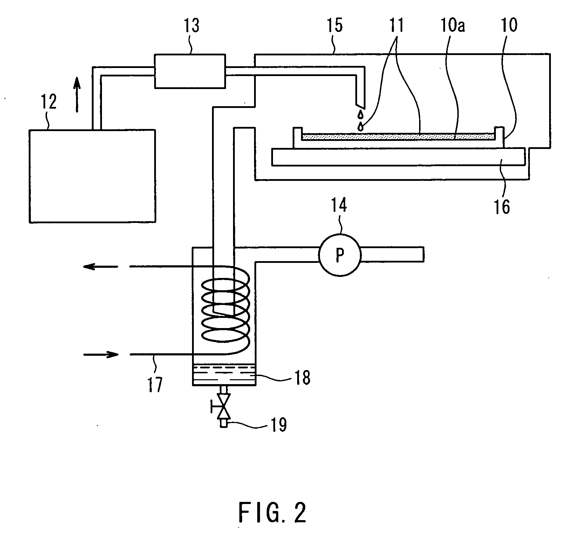

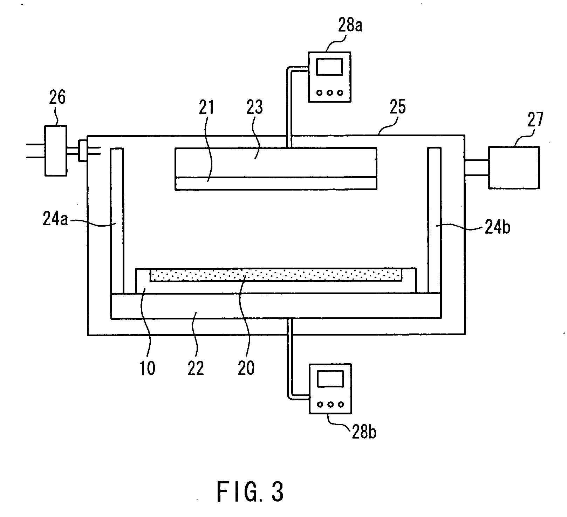

Hereinafter, one embodiment of the present invention will be described in detail with reference to the accompanying drawings where necessary. FIG. 1 is a flowchart illustrating a method for manufacturing a semiconductor substrate according to one embodiment of the present invention. FIGS. 2 and 3 are diagrams schematically showing an example of the apparatus used for the method for manufacturing a semiconductor substrate shown in FIG. 1.

First, a method for producing a copper layer forming material will be described with reference to FIGS. 1 and 2. FIG. 2 is a diagram schematically showing an apparatus for distilling away a solvent from a precursor material for producing a copper layer forming material.

As shown in FIGS. 1 and 2, a precursor material 11 containing a low boiling point solvent is applied uniformly onto a dish-shaped jig 10 made of stainless steel (Step S1). At this time, a fixed amount of the precursor material 11 may be dropped onto the dish-shaped jig 10 from a tank 12 storing the precursor material 11, using a metering portion 13. Since a low boiling point solvent has a low surface tension, the precursor material 11 automatically spreads over the dish-shaped jig 10 when a fixed amount of the precursor material 11 is dropped onto the dish-shaped jig 10. In order to apply the precursor material 11 more uniformly, a low boiling point solvent having a viscosity of 0.1 to 10 mPa·s (e.g., water, methanol, or isopropyl alcohol) may be used. Furthermore, by roughening a surface 10a of the dish-shaped jig 10 onto which the precursor material 11 is dropped, it is possible to prevent the precursor material 11 from being unevenly distributed at the center of the surface 10a. In this case, the surface 10a may be roughened such that its surface roughness Ra (JIS B 0601) is about 0.01 to 100 µm, for example.

Next, with the chamber 15 maintained at a pressure of 1 to 50000 Pa using a pump 14, the dish-shaped jig 10 is heated to 10 to 90°C with a heater 16 to distill away the solvent (low boiling point solvent) contained in the precursor material 11, thereby producing a copper layer forming material 20 (see FIG. 3) (Step S2). At this time, the evaporated solvent may be cooled with a cooling coil 17 through which a refrigerant such as water flows. Consequently, it is possible to remove the collected solvent 18 from a drain 19, and to reuse the solvent 18.

Next, a method for producing a semiconductor substrate using the copper layer forming material 20 obtained by the above-described method will be described with reference to FIGS. 1 and 3. FIG. 3 shows a vapor deposition apparatus for producing a semiconductor substrate using the copper layer forming material 20.

First, the temperature of a base heater 23 is increased such that a semiconductor base 21 can be heated to a temperature range of 120 to 450°C. Further, the temperature of a material heater 22 is increased such that the copper layer forming material 20 can be heated to a temperature range of 90 to 200°C (Step S3). The temperatures of the heaters can be controlled independently by thermoregulators 28a and 28b, respectively.

Next, as shown in FIGS. 1 and 3, the copper layer forming material 20 and the semiconductor base 21 are disposed such that the semiconductor base 21 faces the copper layer forming material 20 in a position vertically above the copper layer forming material 20 (Step S4). In order to deposit copper uniformly, it is preferable to use, as the semiconductor base 21, a base that has a size smaller than the area on the dish-shaped jig 10 to which the copper layer forming material 20 is applied. For example, the area of the semiconductor base 21 may be about 20 to 100% of the area of the region on which the copper layer forming material 20 is applied. In the example shown in FIG. 3, the dish-shaped jig 10 onto which the copper layer forming material 20 is applied is fixed to the material heater 22, and the semiconductor base 21 is fixed to the base heater 23. There is no particular limitation with respect to the method for fixing the semiconductor base 21, and it is possible to use either a mechanical fixing method or a fixing method using adsorption. For example, a holder (not shown) for fixing the semiconductor base 21 may be provided separately. It is particularly preferable that the holder is attached removably to the base heater 23, since the semiconductor base 21 can be cooled promptly at the time of the cooling of the semiconductor base 21 which will be described later. Furthermore, in the case of the vapor deposition apparatus of FIG. 3, the material heater 22 also serves as the material placement portion, and the base heater 23 also serves as the base placement portion. In addition, reference numerals 24a and 24b shown in FIG. 3 denote side walls surrounding the copper layer forming material 20.

In this state, copper is vapor-deposited on the semiconductor base 21 to form a copper layer, thus obtaining a semiconductor substrate. The pressure in a chamber 25 at this time may be 1000 Pa or lower, for example. When the pressure is in this range, the heat conductivity in the chamber 25 is low, so that the temperature of the semiconductor base 21 is higher than the temperatures of other components in the chamber 25. Consequently, the copper contained in the copper layer forming material 20 is vapor-deposited only on the semiconductor base 21. The pressure is adjusted by supplying a certain amount of an inert gas from a gas discharger 26 and monitoring an actual pressure determined by a pressure gauge 27.

After the copper layer is formed by the above-described method, the semiconductor base 21 (the obtained semiconductor substrate) is cooled by discharging a cooling gas into the chamber 25 using the gas discharger 26, with the chamber 25 maintained under an inert atmosphere (Step S5), and the semiconductor substrate is removed.

Although the method for manufacturing a semiconductor substrate according to one embodiment of the present invention has been described above, the invention is not limited to the above-described embodiment. For example, it is possible to dispose the copper layer forming material and the semiconductor base on the respective heaters, and then to increase the temperatures of the heaters to predetermined temperatures. Furthermore, when increasing the temperatures of the heaters to predetermined temperatures, the temperatures may be increased either at once, or gradually.

In the following, examples of the present invention will be described together with comparative examples. It should be noted that the invention is not limited to the following examples.

### Example 1

100 g of a copper compound represented by Formula (2) below (hereinafter, referred to as "copper compound A"), 15 g of ammonium formate and 200 g of 25% ammonia water were dissolved in methanol such that the total volume was 1 liter, thereby preparing a precursor material. It should be noted that theoretically the number of continued units of the copper compound A shown by Formula (2) below can be increased infinitely, like general inorganic compounds, and the properties do not vary with the number of units.

3 ml of this precursor material was dropped onto a dish-shaped jig having a diameter of 10 cm to spread the precursor material over the entire surface of the dish-shaped jig. Subsequently, the dish-shaped jig was heated to 40°C to distill away the solvent, followed by drying the remaining substances in a desiccator (normal pressure). After drying, a blue precipitate (copper layer forming material) was disposed uniformly on the dish-shaped jig. When all of the copper contained in this copper layer forming material is vapor-deposited on the semiconductor base in a vapor deposition step, which will be described later, the film thickness (hereinafter, referred to as "set film thickness") will be 0.8 µm. 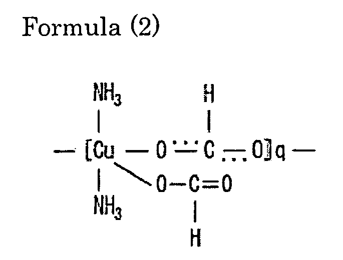 where q represents a positive integer.

Next, copper was vapor-deposited using the above-described vapor deposition apparatus shown in FIG. 3 by the method described below. First, the dish-shaped jig on which the copper layer forming material was disposed uniformly was placed on the material heater, and a semiconductor base was placed on the base heater such that it faced the copper layer forming material. A 50 mm-diameter silicon wafer was used as the semiconductor base. The space between the copper layer forming material and the semiconductor base at this time was 15 mm. Then, the pressure inside the chamber was reduced, and thereafter the pressure in the chamber was adjusted to 100 Pa, using nitrogen gas. Subsequently, the dish-shaped jig and the semiconductor base were heated to 150°C and 250°C, respectively, with the respective heaters, thereby vapor-depositing copper on the semiconductor base over about 90 minutes. Thereafter, with the pressure in the chamber maintained at 100 Pa, the obtained semiconductor substrate was cooled. After the temperature of the semiconductor substrate reached 60°C, the chamber was brought back to normal pressure, and the semiconductor substrate was removed. It should be noted that, in the following examples, the same silicon wafer as described above was used as the semiconductor base.

As a result of measuring the thickness of the copper layer of the obtained semiconductor substrate using an electrolytic film thickness meter, the thickness was 0.8 µm. In addition, visual inspection confirmed that the obtained copper layer had a uniform and smooth surface. Further, no problem was observed during an electric conduction test using a tester (space between terminals: 20 mm). Moreover, the obtained copper layer was evaluated by the Electron Spectroscopy for Chemical Analysis (ESCA) described below.

### Method of analysis by ESCA

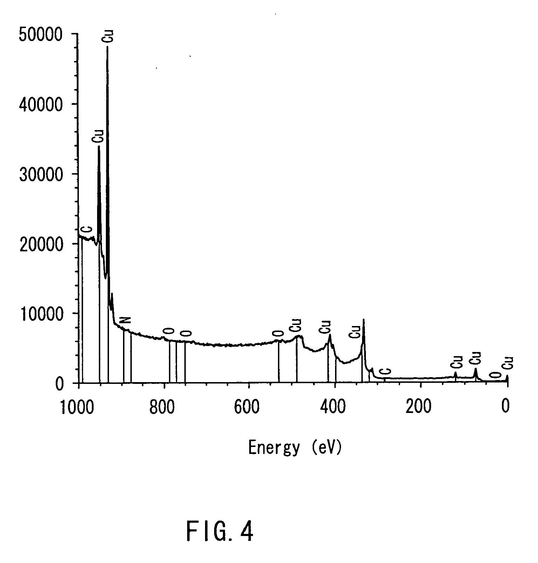

The obtained copper layer was analyzed with an X-ray photoelectron spectroscopic analyzer (JPS-9010MC) manufactured by JEOL Ltd., using MgKα as a radiation source. Before the analysis, 5 nm of the outermost surface of the copper layer was etched away with an argon ion, thus removing the contaminant on the outermost surface. The results are shown in FIGS. 4 to 6.

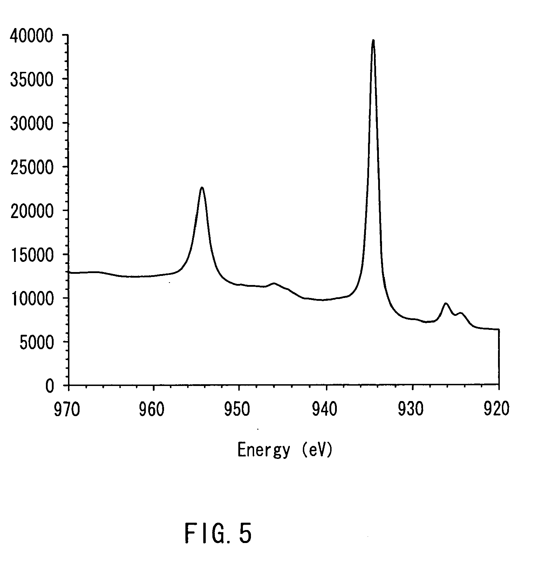

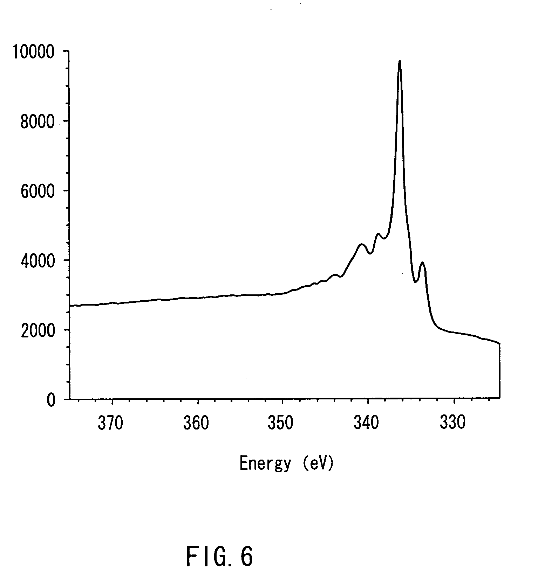

As shown in the wide-scan spectrum of FIG. 4, almost no peaks other than those of copper were observed. In addition, as shown in FIG. 5, in the narrow-scan spectrum for copper 2p, no peak corresponding to Cu²⁺ was observed. Furthermore, as shown in FIG. 6, in the pattern of Auger peaks of the narrow-scan spectrum for copper, only peaks attributed to metallic copper (Cu), instead of those attributed to Cu⁺, were observed. The above-described results confirmed that the copper layer obtained in Example 1 was made of metallic copper containing no impurities.

### Example 2

50 g of the copper compound A, 8 g of ammonium formate, 5 g of propylene glycol and 200 g of 25% ammonia water were dissolved in IPA such that the total volume was 1 liter, thereby preparing a precursor material (set film thickness: 0.4 µm). 3 ml of this precursor material was dropped onto a dish-shaped jig having a diameter of 10 cm to spread the precursor material over the entire surface of the dish-shaped jig. Subsequently, the dish-shaped jig was heated to 30°C to distill away the solvent. This distillation was performed, with the ambient pressure surrounding the dish-shaped jig being reduced to 3 kPa using an aspirator. Thereafter, the remaining substances were dried in a desiccator (normal pressure). After drying, a blue precipitate (copper layer forming material) was disposed uniformly on the dish-shaped jig. Next, copper was vapor-deposited using the above-described vapor deposition apparatus shown in FIG. 3 by the method described below. First, the dish-shaped jig on which the copper layer forming material was disposed uniformly was placed on the material heater, and a semiconductor base was placed on the base heater such that it faced the copper layer forming material. The space between the copper layer forming material and the semiconductor base at this time was 25 mm. Then, the pressure inside the chamber was reduced, and thereafter the pressure in the chamber was adjusted to 50 Pa, using nitrogen gas. Subsequently, the dish-shaped jig and the semiconductor base were heated to 130°C and 150°C, respectively, with the respective heaters, thereby vapor-depositing copper on the semiconductor base over about 3 hours. Thereafter, the semiconductor substrate was cooled by introducing a large amount of nitrogen gas into the chamber (normal pressure). After the temperature of the semiconductor substrate reached 50°C, the introduction of the nitrogen gas was stopped, and the semiconductor substrate was removed.

As a result of measuring the thickness of the copper layer of the obtained semiconductor substrate using an electrolytic film thickness meter, the thickness was 0.4 µm. Further, no problem was observed during an electric conduction test using a tester (space between terminals: 20 mm). Moreover, as a result of evaluating the obtained copper layer by ESCA in the same manner as in Example 1 described above, it was confirmed that the copper layer was made of metallic copper containing no impurities.

### Example 3

150 g of the copper compound A, 75 g of ammonium formate and 150 g of propylene glycol were dissolved in 5% ammonia water such that the total volume was 1 liter, thereby preparing a precursor material (set film thickness: 1.2 µm). 3 ml of this precursor material was dropped onto a dish-shaped jig having a diameter of 10 cm to spread the precursor material over the entire surface of the dish-shaped jig. Subsequently, the dish-shaped jig was heated to 50°C to distill away the solvent. This distillation was performed with the pressure being adjusted to 10 kPa by introducing nitrogen gas, while reducing the ambient pressure surrounding the dish-shaped jig using an aspirator. Thereafter, the remaining substances were dried in a desiccator (normal pressure). After drying, a blue precipitate (copper layer forming material) was disposed uniformly on the dish-shaped jig. Next, copper was vapor-deposited using the above-described vapor deposition apparatus shown in FIG. 3 by the method described below. First, the dish-shaped jig on which the copper layer forming material was disposed uniformly was placed on the material heater, and a semiconductor base was placed on the base heater such that it faced the copper layer forming material. The space between the copper layer forming material and the semiconductor base at this time was 50 mm. Then, the pressure inside the chamber was reduced, and thereafter the degree of vacuum in the chamber was adjusted to 100 Pa, using nitrogen gas. Subsequently, the dish-shaped jig and the semiconductor base were heated to 150°C and 280°C, respectively, with the respective heaters, thereby vapor-depositing copper on the semiconductor base over about 90 minutes. Thereafter, the semiconductor substrate was cooled by introducing a large amount of nitrogen gas into the chamber (normal pressure). After the temperature of the semiconductor substrate reached 60°C, the introduction of the nitrogen gas was stopped, and the semiconductor substrate was removed.

As a result of measuring the thickness of the copper layer of the obtained semiconductor substrate using an electrolytic film thickness meter, the thickness was 1.2 µm. Further, no problem was observed during an electric conduction test using a tester (space between terminals: 20 mm). Moreover, as a result of evaluating the obtained copper layer by ESCA in the same manner as in Example 1 described above, it was confirmed that the copper layer was made of metallic copper containing no impurities.

### Example 4

120 g of copper formate tetrahydrate, 40 g of ammonium formate, 200 g of 25% ammonia water and 50 g of benzyl alcohol were dissolved in methanol such that the total volume was 1 liter, thereby preparing a precursor material (set film thickness: 0.8 µm). 3 ml of this precursor material was dropped onto a dish-shaped jig having a diameter of 10 cm to spread the precursor material over the entire surface of the dish-shaped jig. Subsequently, the dish-shaped jig was heated to 40°C to distill away the solvent. This distillation was performed with the degree of vacuum being adjusted to 7 kPa by introducing air, while reducing the ambient pressure surrounding the dish-shaped jig using an aspirator. Thereafter, the remaining substances were dried in a desiccator (normal pressure). After drying, a blue precipitate (copper layer forming material) was disposed uniformly on the dish-shaped jig. Next, copper was vapor-deposited using the above-described vapor deposition apparatus shown in FIG. 3 by the method described below. First, the dish-shaped jig on which the copper layer forming material was disposed uniformly was placed on the material heater, and a semiconductor base was placed on the base heater such that it faced the copper layer forming material. The space between the copper layer forming material and the semiconductor base at this time was 35 mm. Then, the pressure inside the chamber was reduced, and thereafter the pressure in the chamber was adjusted to 20 Pa, using argon gas. Subsequently, the dish-shaped jig and the semiconductor base were heated to 150°C and 200°C, respectively, with the respective heaters, thereby vapor-depositing copper on the semiconductor base over about 90 minutes. Thereafter, the obtained semiconductor substrate was cooled, with the pressure in the chamber maintained at 20 Pa. After the temperature of the semiconductor substrate reached 60°C, the chamber was brought back to normal pressure, and the semiconductor substrate was removed.

As a result of measuring the thickness of the copper layer of the obtained semiconductor substrate using an electrolytic film thickness meter, the thickness was 0.8 µm. Further, no problem was observed during an electric conduction test using a tester (space between terminals: 20 mm). Moreover, as a result of evaluating the obtained copper layer by ESCA in the same manner as in Example 1 described above, it was confirmed that the copper layer was made of metallic copper containing no impurities.

### Example 5

95 g of copper formate tetrahydrate, 40 g of ammonium formate, 200 g of 25% ammonia water and 40 g of propylene glycol were dissolved in IPA such that the total volume was 1 liter, thereby preparing a precursor material (set film thickness: 0.6 µm). Using this precursor material, a copper layer forming material was disposed on the dish-shaped jig in the same manner as in Example 4. Next, copper was vapor-deposited using the above-described vapor deposition apparatus shown in FIG. 3 by the method described below. First, the dish-shaped jig on which the copper layer forming material was disposed uniformly was placed on the material heater, and a semiconductor base was placed on the base heater such that it faced the copper layer forming material. The space between the copper layer forming material and the semiconductor base at this time was 15 mm. Then, the pressure inside the chamber was reduced to 5 Pa. Subsequently, the dish-shaped jig and the semiconductor base were heated to 150°C and 250°C, respectively, with the respective heaters, thereby vapor-depositing copper on the semiconductor base over about 90 minutes. Thereafter, the obtained semiconductor substrate was cooled, with the pressure in the chamber maintained at 5 Pa. After the temperature of the semiconductor substrate reached 60°C, the chamber was brought back to normal pressure, and the semiconductor substrate was removed.

As a result of measuring the thickness of the copper layer of the obtained semiconductor substrate using an electrolytic film thickness meter, the thickness was 0.6 µm. Further, no problem was observed during an electric conduction test using a tester (space between terminals: 20 mm). Moreover, as a result of evaluating the obtained copper layer by ESCA in the same manner as in Example 1 described above, it was confirmed that the copper layer was made of metallic copper containing no impurities.

### Example 6

47.5 g of copper formate tetrahydrate, 20 g of ammonium formate, 200 g of 25% ammonia water and 20 g of propylene glycol were dissolved in IPA such that the total volume was 1 liter, thereby preparing a precursor material (set film thickness: 0.3 µm). Using this precursor material, a copper layer forming material was disposed on the dish-shaped jig in the same manner as in Example 3. Next, copper was vapor-deposited using the above-described vapor deposition apparatus shown in FIG. 3 by the method described below. First, the dish-shaped jig on which the copper layer forming material was disposed uniformly was placed on the material heater, and a semiconductor base was placed on the base heater such that it faced the copper layer forming material. The space between the copper layer forming material and the semiconductor base at this time was 15 mm. Then, the pressure inside the chamber was reduced, and thereafter adjusted to 300 Pa, using argon gas. Subsequently, the dish-shaped jig and the semiconductor base were heated to 150°C and 250°C, respectively, with the respective heaters, thereby vapor-depositing copper on the semiconductor base over about 90 minutes. Thereafter, the obtained semiconductor substrate was cooled, with the pressure in the chamber maintained at 300 Pa. After the temperature of the semiconductor substrate reached 60°C, the chamber was brought back to normal pressure, and the semiconductor substrate was removed.

As a result of measuring the thickness of the copper layer of the obtained semiconductor substrate using an electrolytic film thickness meter, the thickness was 0.3 µm. Further, no problem was observed during an electric conduction test using a tester (space between terminals: 20 mm). Moreover, as a result of evaluating the obtained copper layer by ESCA in the same manner as in Example 1 described above, it was confirmed that the copper layer was made of metallic copper containing no impurities.

### Example 7

180 g of copper formate tetrahydrate, 130 g of ammonium formate and 75 g of butylene glycol were dissolved in 5% ammonia water such that the total volume was 1 liter, followed by filtration of any insoluble matter, thereby preparing a precursor material (set film thickness: 1.2 µm). Using this precursor material, a copper layer forming material was disposed on the dish-shaped jig in the same manner as in Example 3. Next, copper was vapor-deposited using the above-described vapor deposition apparatus shown in FIG. 3 by the method described below. First, the dish-shaped jig on which the copper layer forming material was disposed uniformly was placed on the material heater, and a semiconductor base was placed on the base heater such that it faced the copper layer forming material. The space between the copper layer forming material and the semiconductor base at this time was 30 mm. Then, the pressure inside the chamber was reduced, and thereafter adjusted to 10 Pa, using nitrogen gas. Subsequently, with the temperature of the semiconductor base maintained at 300°C, the temperature of the dish-shaped jig was increased to 120°C at a temperature increasing rate of 10°C/min, and then increased to 200°C at a temperature increasing rate of 2°C/min. Immediately after the temperature reached 200°C, the semiconductor substrate was cooled by introducing a large amount of nitrogen gas into the chamber (normal pressure). After the temperature of the semiconductor substrate reached 60°C, the introduction of the nitrogen gas was stopped, and the semiconductor substrate was removed.

As a result of measuring the thickness of the copper layer of the obtained semiconductor substrate using an electrolytic film thickness meter, the thickness was 1.2 µm. Further, no problem was observed during an electric conduction test using a tester (space between terminals: 20 mm). Moreover, as a result of evaluating the obtained copper layer by ESCA in the same manner as in Example 1 described above, it was confirmed that the copper layer was made of metallic copper containing no impurities.

### Example 8

95 g of copper formate tetrahydrate, 40 g of ammonium formate, 200 g of 25% ammonia water and 40 g of propylene glycol were dissolved in IPA such that the total volume was 1 liter, thereby preparing a precursor material (set film thickness: 0.6 µm). Using this precursor material, a copper layer forming material was disposed on the dish-shaped jig in the same manner as in Example 2. Next, copper was vapor-deposited using the above-described vapor deposition apparatus shown in FIG. 3 by the method described below. First, the dish-shaped jig on which the copper layer forming material was disposed uniformly was placed on the material heater, and a semiconductor base was placed on the base heater such that it faced the copper layer forming material. The space between the copper layer forming material and the semiconductor base at this time was 10 mm. Then, the pressure inside the chamber was reduced, and thereafter adjusted to 500 Pa, using nitrogen gas. Subsequently, the dish-shaped jig and the semiconductor base were heated to 150°C and 250°C, respectively, with the respective heaters, thereby vapor-depositing copper on the semiconductor base over about 90 minutes. Thereafter, the obtained semiconductor substrate was cooled, with the pressure in the chamber maintained at 500 Pa. After the temperature of the semiconductor substrate reached 60°C, the chamber was brought back to normal pressure, and the semiconductor substrate was removed.

As a result of measuring the thickness of the copper layer of the obtained semiconductor substrate using an electrolytic film thickness meter, the thickness was 0.6 µm. Further, no problem was observed during an electric conduction test using a tester (space between terminals: 20 mm). Moreover, as a result of evaluating the obtained copper layer by ESCA in the same manner as in Example 1 described above, it was confirmed that the copper layer was made of metallic copper containing no impurities.

### Example 9

A copper layer forming material was disposed on the dish-shaped jig in the same manner as in Example 1 (set film thickness: 0.8 µm). Next, copper was vapor-deposited using the above-described vapor deposition apparatus shown in FIG. 3 by the method described below. First, the dish-shaped jig on which the copper layer forming material was disposed uniformly was placed on the material heater, and a semiconductor base was placed on the base heater such that it faced the copper layer forming material. The space between the copper layer forming material and the semiconductor base at this time was 20 mm. Then, the pressure inside the chamber was reduced to 5 Pa. Subsequently, the dish-shaped jig and the semiconductor base were heated to 100°C and 140°C, respectively, with the respective heaters, thereby vapor-depositing copper on the semiconductor base over about 6 hours. Thereafter, the obtained semiconductor substrate was cooled, with the pressure in the chamber maintained at 5 Pa. After the temperature of the semiconductor substrate reached 60°C, the chamber was brought back to normal pressure, and the semiconductor substrate was removed.

As a result of measuring the thickness of the copper layer of the obtained semiconductor substrate using an electrolytic film thickness meter, the thickness was 0.1 µm. Further, no problem was observed during an electric conduction test using a tester (space between terminals: 20 mm). Moreover, as a result of evaluating the obtained copper layer by ESCA in the same manner as in Example 1 described above, it was confirmed that the copper layer was made of metallic copper containing no impurities.

### Example 10

A copper layer forming material was disposed on the dish-shaped jig in the same manner as in Example 2 (set film thickness: 0.4 µm). Next, copper was vapor-deposited using the above-described vapor deposition apparatus shown in FIG. 3 by the method described below. First, the dish-shaped jig on which the copper layer forming material was disposed uniformly was placed on the material heater, and a semiconductor base was placed on the base heater such that it faced the copper layer forming material. The space between the copper layer forming material and the semiconductor base at this time was 80 mm. Then, the pressure inside the chamber was reduced to 5 Pa. Subsequently, the dish-shaped jig and the semiconductor base were heated to 150°C and 250°C, respectively, with the respective heaters, thereby vapor-depositing copper on the semiconductor base over about 90 minutes. Thereafter, the obtained semiconductor substrate was cooled, with the pressure in the chamber maintained at 5 Pa. After the temperature of the semiconductor substrate reached 60°C, the chamber was brought back to normal pressure, and the semiconductor substrate was removed.

As a result of measuring the thickness of the copper layer of the obtained semiconductor substrate using an electrolytic film thickness meter, the thickness was 0.1 µm. Further, no problem was observed during an electric conduction test using a tester (space between terminals: 20 mm). Moreover, as a result of evaluating the obtained copper layer by ESCA in the same manner as in Example 1 described above, it was confirmed that the copper layer was made of metallic copper containing no impurities.

### Example 11

Using the precursor material of Example 1, a copper layer forming material was disposed on the dish-shaped jig in the same manner as in Example 3 (set film thickness: 0.8 µm). Next, copper was vapor-deposited using the above-described vapor deposition apparatus shown in FIG. 3 by the method described below. First, the dish-shaped jig on which the copper layer forming material was disposed uniformly was placed on the material heater, and a semiconductor base was placed on the base heater such that it faced the copper layer forming material. The space between the copper layer forming material and the semiconductor base at this time was 20 mm. Then, the pressure inside the chamber was reduced, and thereafter adjusted to 5000 Pa, using nitrogen gas. Subsequently, the dish-shaped jig and the semiconductor base were heated to 150°C and 250°C, respectively, with the respective heaters, thereby vapor-depositing copper on the semiconductor base over about 90 minutes. Thereafter, the obtained semiconductor substrate was cooled, with the chamber maintained at 5000 Pa. After the temperature of the semiconductor substrate reached 60°C, the chamber was brought back to normal pressure, and the semiconductor substrate was removed.

As a result of measuring the thickness of the copper layer of the obtained semiconductor substrate using an electrolytic film thickness meter, the thickness was 0.1 µm. Further, no problem was observed during an electric conduction test using a tester (space between terminals: 20 mm). Moreover, as a result of evaluating the obtained copper layer by ESCA in the same manner as in Example 1 described above, it was confirmed that the copper layer was made of metallic copper containing no impurities.

### Example 12

A silicone-based adhesive (containing SD4570 manufactured by Dow Corning Toray Co., Ltd., SRX212 manufactured by Dow Corning Toray Co., Ltd. and toluene at a weight ratio of 1:0.1:5) was applied onto one side of a polyimide film (Kapton 100H manufactured by DU PONT-TORAY CO., LTD.), and the whole was air-dried, followed by heating for 10 minutes in an oven at 100°C, thereby curing the silicone-based adhesive. As a result of measuring the thickness of a layer of the silicone-based adhesive with a micrometer, the thickness was 20 µm. Powder of the copper compound A was sprinkled onto the silicone-based adhesive layer such that it was fixed onto the silicone-based adhesive layer, and the excess copper compound A was removed, thereby obtaining a polyimide film onto which the powder was attached uniformly. The amount of the copper compound A attached was 20 g/m². In addition, the set film thickness of this example was 0.25 µm.

Next, copper was vapor-deposited using the above-described vapor deposition apparatus shown in FIG. 3 by the method described below. First, the polyimide film on which the copper compound A was disposed uniformly was placed on the material heater, and a semiconductor base was placed on the base heater such that it faced the copper compound A. The space between the copper compound A (copper layer forming material) and the semiconductor base at this time was 15 mm. Then, the pressure inside the chamber was reduced, and thereafter adjusted to 20 Pa, using nitrogen gas. Subsequently, the polyimide film and the semiconductor base were heated to 150°C and 200°C, respectively, with the respective heaters, thereby vapor-depositing copper on the semiconductor base over about 90 minutes. Thereafter, the obtained semiconductor substrate was cooled, with the pressure in the chamber maintained at 20 Pa. After the temperature of the semiconductor substrate reached 60°C, the chamber was brought back to normal pressure, and the semiconductor substrate was removed.

As a result of measuring the thickness of the copper layer of the obtained semiconductor substrate using an electrolytic film thickness meter, the thickness was 0.25 µm. Further, no problem was observed during an electric conduction test using a tester (space between terminals: 20 mm). Moreover, as a result of evaluating the obtained copper layer by ESCA in the same manner as in Example 1 described above, it was confirmed that the copper layer was made of metallic copper containing no impurities.

### Example 13

100 g of copper formate tetrahydrate was dissolved in methanol such that the total volume was 1 liter, thereby preparing a precursor material (set film thickness: 0.57 µm). 20 ml of this precursor material was dropped onto a dish-shaped jig having a diameter of 10 cm to spread the precursor material over the entire surface of the dish-shaped jig. Subsequently, the dish-shaped jig was heated to 40°C to distill away the solvent. This distillation was performed with the degree of vacuum being adjusted to 7 kPa by introducing air, while reducing the ambient pressure surrounding the dish-shaped jig using an aspirator. Thereafter, the remaining substances were dried in a desiccator (normal pressure). After drying, a blue precipitate (copper layer forming material) was disposed uniformly on the dish-shaped jig. Next, copper was vapor-deposited using the above-described vapor deposition apparatus shown in FIG. 3 by the method described below. First, the dish-shaped jig on which the copper layer forming material was disposed uniformly was placed on the material heater, and a semiconductor base was placed on the base heater such that it faced the copper layer forming material. The space between the copper layer forming material and the semiconductor base at this time was 35 mm. Then, the pressure inside the chamber was reduced, and thereafter adjusted to 20 Pa, using nitrogen gas. Subsequently, the dish-shaped jig and the semiconductor base were heated to 200°C and 250°C, respectively, with the respective heaters, thereby vapor-depositing copper on the semiconductor base over about 30 minutes. Thereafter, the obtained semiconductor substrate was cooled, with the pressure in the chamber maintained at 20 Pa. After the temperature of the semiconductor substrate reached 60°C, the chamber was brought back to normal pressure, and the semiconductor substrate was removed.

As a result of measuring the thickness of the copper layer of the obtained semiconductor substrate using an electrolytic film thickness meter, the thickness was 0.40 µm. Further, no problem was observed during an electric conduction test using a tester (space between terminals: 20 mm). Moreover, as a result of evaluating the obtained copper layer by ESCA in the same manner as in Example 1 described above, it was confirmed that the copper layer was made of metallic copper containing no impurities.

### Example 14

A silicone-based adhesive (containing SD4570 manufactured by Dow Corning Toray Co., Ltd., SRX212 manufactured by Dow Corning Toray Co., Ltd. and toluene at a weight ratio of 1:0.1:5) was applied onto one side of a polyimide film (Kapton 100H manufactured by DU PONT-TORAY CO., LTD.), and the whole was air-dried, followed by heating for 10 minutes in an oven at 100°C, thereby curing the silicone-based adhesive. As a result of measuring the thickness of a layer of the silicone-based adhesive with a micrometer, the thickness was 20 µm. Powder of copper formate tetrahydrate was sprinkled onto the silicone-based adhesive layer such that it was fixed onto the silicone-based adhesive layer, and excess copper formate tetrahydrate was removed, thereby obtaining a polyimide film onto which the powder was attached uniformly. The amount of copper formate tetrahydrate attached was 20 g/m². In addition, the set film thickness of this example was 0.15 µm. Next, copper was vapor-deposited using the above-described vapor deposition apparatus shown in FIG. 3 by the method described below. First, the polyimide film on which copper formate tetrahydrate was disposed uniformly was placed on the material heater, and a semiconductor base was placed on the base heater such that it faced the copper formate tetrahydrate. The space between the copper formate tetrahydrate (copper layer forming material) and the semiconductor base at this time was 15 mm. Then, the pressure inside the chamber was reduced, and thereafter adjusted to 20 Pa, using nitrogen gas. Subsequently, the polyimide film and the semiconductor base were heated to 150°C and 200°C, respectively, with the respective heaters, thereby vapor-depositing copper on the semiconductor base over about 90 minutes. Thereafter, the obtained semiconductor substrate was cooled, with the pressure in the chamber maintained at 20 Pa. After the temperature of the semiconductor substrate reached 60°C, the chamber was brought back to normal pressure, and the semiconductor substrate was removed.

As a result of measuring the thickness of the copper layer of the obtained semiconductor substrate using an electrolytic film thickness meter, the thickness was 0.12 µm. Further, no problem was observed during an electric conduction test using a tester (space between terminals: 20 mm). Moreover, as a result of evaluating the obtained copper layer by ESCA in the same manner as in Example 1 described above, it was confirmed that the copper layer was made of metallic copper containing no impurities.

### Comparative Example 1

A copper layer forming material was disposed on the dish-shaped jig in the same manner as in Example 1 (set film thickness: 0.8 µm). Next, copper was vapor-deposited using the above-described vapor deposition apparatus shown in FIG. 3 by the method described below. First, the dish-shaped jig on which the copper layer forming material was disposed uniformly was placed on the material heater, and a semiconductor base was placed on the base heater such that it faced the copper layer forming material. The space between the copper layer forming material and the semiconductor base at this time was 50 mm. Then, the pressure inside the chamber was reduced to 5 Pa. Subsequently, the dish-shaped jig and the semiconductor base were heated to 60°C and 100°C, respectively, with the respective heaters. Thereafter, the semiconductor base was cooled, with the pressure in the chamber maintained at 5 Pa. After the temperature of the semiconductor base reached 60°C, the chamber was brought back to normal pressure, and the semiconductor base was removed. No copper was vapor-deposited on the surface of the removed semiconductor base.

### Comparative Example 2

A copper layer forming material was disposed on the dish-shaped jig in the same manner as in Example 7 (set film thickness: 0.8 µm). Next, copper was vapor-deposited using the above-described vapor deposition apparatus shown in FIG. 3 by the method described below. First, the dish-shaped jig on which the copper layer forming material was disposed uniformly was placed on the material heater, and a semiconductor base was placed on the base heater such that it faced the copper layer forming material. The space between the copper layer forming material and the semiconductor base at this time was 15 mm. Then, with the chamber maintained at normal pressure, the dish-shaped jig and the semiconductor base were heated to 250°C and 250°C, respectively, with the respective heaters. Thereafter, the semiconductor base was cooled, with the chamber maintained at normal pressure. After the temperature of the semiconductor base reached 60°C, the semiconductor base was removed. No copper was vapor-deposited on the surface of the removed semiconductor base.

The method for manufacturing a substrate according to the present invention, and the vapor deposition apparatus used for the method are useful for manufacturing substrates such as a semiconductor substrate and an electronic substrate, for which the miniaturization of the copper layer is required.

## Claims

1. A method for manufacturing a substrate comprising a base, and a copper layer formed on the base, the method comprising the steps of:
positioning a copper layer forming material comprising a constituent material of the copper layer and the base such that the base faces the copper layer forming material in a position vertically above the copper layer forming material; and
vapor-depositing copper on the base by heating the copper layer forming material to a temperature range of 90 to 200°C and heating the base to a temperature range of 120 to 450°C, thereby forming the copper layer.

2. The method for manufacturing a substrate according to claim 1,
wherein the copper layer forming material and the base are disposed such that the space between the copper layer forming material and the base is 5 to 100 mm.

3. The method for manufacturing a substrate according to claim 1,
wherein the copper layer forming material comprises a copper compound including one unit represented by Formula (1) below or a plurality of the units that are coupled together:
Formula (1) [RCOO]₂[NH₃]₂CuXₚ
wherein two Rs each represent one selected from H, NH₂, CH₂Y, CH₂Y (CHZ) and CH₂Y (CHZ)₄, and may be either the same or different,
X represents H₂O or a solvent molecule,
p is 0 or 1,
Y represents one selected from H, OH and NH₂, and
Z represents one selected from H and OH.

4. The method for manufacturing a substrate according to claim 1,
wherein the copper layer forming material comprises a formate ion, a copper ion and an ammonium ion.

5. The method for manufacturing a substrate according to claim 1,
wherein the copper layer forming material and the base are heated, with the pressure around the copper layer forming material and the base maintained at 1000 Pa or lower.

6. The method for manufacturing a substrate according to claim 1,
wherein, after forming the copper layer, the base is cooled under an inert atmosphere.

7. The method for manufacturing a substrate according to claim 6,
wherein the base is cooled until the temperature of the base reaches 100°C or lower.

8. A vapor deposition apparatus for manufacturing a substrate comprising a base, and a copper layer formed on the base, the apparatus comprising:
a material placement portion for positioning a copper layer forming material comprising a constituent material of the copper layer;
a base placement portion for positioning the base, the base placement portion being provided facing the material placement portion in a position vertically above the material placement portion;
a material heating portion for heating the copper layer forming material to a temperature range of 90 to 200°C; and
a base heating portion for heating the base to a temperature range of 120 to 450°C.

9. The vapor deposition apparatus according to claim 8,
further comprising a cooler for cooling the base.

10. The vapor deposition apparatus according to claim 8,
further comprising means for adjusting a pressure by further supplying an inert gas.
